# EUROPÄISCHE PATENTSCHRIFT

(11) **EP 2 526 431 B1**
(45) Veröffentlichungstag und Bekanntmachung des Hinweises auf die Patenterteilung: **21.01.2015**
(21) Anmeldenummer: 10790910.3
(22) Anmeldetag: 26.11.2010
(51) Int. Cl.: G01R 23/15, G01R 31/28, H03K 5/19

(54) **VERFAHREN UND VORRICHTUNG ZUR ÜBERWACHUNG EINES FREQUENZSIGNALS**
METHOD AND DEVICE FOR MONITORING A FREQUENCY SIGNAL
PROCÉDÉ ET DISPOSITIF DE CONTRÔLE D'UN SIGNAL DE FRÉQUENCE

(30) Priorität: 18.01.2010 DE 102010000962
(43) Veröffentlichungstag der Anmeldung: 28.11.2012
(73) Patentinhaber: Robert Bosch GmbH, 70442 Stuttgart (DE)
(72) Erfinder: BAUS, Michael, 74321 Bietigheim-Bissingen (DE); STEMMLER, Michael, 76646 Bruchsal (DE)
(86) Internationale Anmeldenummer: PCT/EP2010/068307
(87) Internationale Veröffentlichungsnummer: WO 2011/085855

(56) Entgegenhaltungen:
- EP-A1- 1 675 267
- WO-A2-2006/104770
- DE-A1- 10 347 413
- US-A- 5 657 361

## Beschreibung

### Stand der Technik

Die vorliegende Erfindung bezieht sich auf ein Verfahren zur Überwachung gemäß dem Oberbegriff des Anspruchs 1, eine Vorrichtung zur Überwachung gemäß dem Oberbegriff des Anspruchs 7, sowie eine Überwachungsvorrichtung zur Überwachung gemäß dem Oberbegriff des Anspruchs 9.

Digitale und analog getaktete Sensoren benötigen oftmals einen Takt zum Arbeiten. Dieser Takt kann entweder extern eingespeist oder über einen Oszillator erzeugt werden. Bei Drehratensensoren wird der mechanische Sensor selbst als Oszillator verwendet, um einen internen Takt über eine gewöhnliche Phase-Locked-Loop-Schaltungen (PLL) zu erzeugen. Für Sensoren mit sicherheitskritischen Funktionen, die beispielsweise in der Sensorik von Fahrzeugstabilisierungsprogrammen (ESP) zum Einsatz kommen, wird eine hohe Anforderung an die Funktionssicherheit des Sensors gestellt. Hierzu gehört unter anderem die Überwachung des genutzten Taktes. Zum einen dient die Überwachung dazu, Rückschlüsse auf die interne Signalverarbeitung zu ziehen und zum anderen lassen sich bei Drehratensensoren Rückschlüsse auf die mechanische Funktionalität des Sensorelementes ziehen, wenn die Frequenz überwacht wird, die sich aus dem genutzten Takt ableiten lässt.

Heute sind vier Arten der Frequenzüberwachungen bekannt und werden teilweise in aktuellen Bosch Sensor Generationen, wie z. B. MM3 oder MM5 oder möglicherweise auch in Wettbewerbsprodukten eingesetzt. Folgende Methoden werden angewandt:
1) Eine logische Überwachung, über eine digitale Schnittstelle, beispielsweise SPI.
2) Eine Überwachung mittels eines zweiten, von außen eingespeisten Taktes.
3) Eine Überwachung über einen Quarz oder andersartigen Oszillator, der zusätzlich zum mechanischen Oszillator verwendet wird.
4) Eine Überwachung mittels eines Taktes, der vom Sensor nach außen gegeben und von einer externen Einheit überwacht wird.

In der DE 103 47 413 A1 wird ein Steuergerät mit einer getakteten Datenübertragung zwischen einem Prozessor und wenigstens einer weiteren Schaltung gezeigt, wobei der Prozessor selbst den Takt ausgibt. Der Prozessor überwacht den Takt anhand von den Ausgangssignalen wenigstens zweier Taktausgänge.

In der US 5 657 361 A (INAGAKI YASUKUNI) wird ein Verfahren zur Überwachung des Frequenzsignals eines externen Oszillators beschreibt.

### Offenbarung der Erfindung

Vor diesem Hintergrund wird mit der vorliegenden Erfindung ein Verfahren, weiterhin eine Vorrichtung und eine Überwachungsvorrichtung, das dieses Verfahren verwendet, sowie schließlich ein entsprechendes Computerprogrammprodukt, gemäß den unabhängigen Patentansprüchen vorgestellt. Vorteilhafte Ausgestaltungen ergeben sich aus den jeweiligen Unteransprüchen und der nachfolgenden Beschreibung.

Die vorliegende Erfindung schafft ein Verfahren zur Überwachung eines Frequenzsignals, das innerhalb einer Einheit bereitgestellt wird, wobei das Verfahren die folgenden Schritte aufweist:
- Empfangen eines oder mehrerer binärer Signalpegel eines Taktsignals oder eines Steuersignals von einer Kommunikationsschnittstelle, wobei die Kommunikationsschnittstelle ausgebildet ist, um Informationen entsprechend einem Kommunikationsprotokoll zu übertragen;
- Bereitstellen des Frequenzsignals in der Einheit; und
- Vergleichen des Frequenzsignals mit einer zeitlichen Folge von Signalpegels des von der Kommunikationsschnittstelle empfangenen Taktsignals, um ein Vergleichsergebnis zu erhalten oder Steuern eines Zählers durch das Steuersignal und das Frequenzsignal, um einen Zählerstand zu erhalten; und
- Erkennen einer vorbestimmten Qualität des Frequenzsignals, wenn das Vergleichsergebnis ein vorbestimmtes Kriterium erfüllt oder wenn der Zähler-stand innerhalb eines vorbestimmten Wertebereiches liegt, um durch die erkannte Qualität des Frequenzsignals dieses zu überwachen.

Die vorliegende Erfindung schafft ferner eine Vorrichtung, die ausgebildet ist, um die Schritte des erfindungsgemäßen Verfahrens durchzuführen bzw. umzusetzen. Insbesondere kann die Vorrichtung Einrichtungen aufweisen, die ausgebildet sind, um je einen Schritt des Verfahrens auszuführen. Auch durch diese Ausführungsvariante der Erfindung in Form einer Vorrichtung oder eines Steuergeräts kann die der Erfindung zugrunde liegende Aufgabe schnell und effizient gelöst werden.

Unter einer Vorrichtung oder einem Steuergerät kann vorliegend ein Steuergerät oder allgemein ein elektrisches Gerät verstanden werden, das z.B. Sensorsignale verarbeitet und in Abhängigkeit davon Steuersignale oder physikalische Messwerte ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Die vorliegende Erfindung schafft weiterhin eine Überwachungsvorrichtung zur Überwachung eines Frequenzsignals, wobei die Überwachungsvorrichtung folgende Merkmale aufweist:
- eine Vorrichtung, wie sie vorstehend beschrieben wurde;
- ein Busübertragungssystem, das mit der Kommunikationsschnittstelle der Vorrichtung verbunden ist und zur Datenübertragung von der Vorrichtung zu einer Steuereinheit ausgebildet ist;
- die Steuereinheit, die zur Ausgabe eines Taktsignals oder eines Steuersignals zur Aktivierung der Vorrichtung ausgebildet ist, wobei die Steuereinheit ferner ausgebildet ist, um eine Überwachung des Frequenzsignals derart auszuführen, dass ein Fehlerwarnsignal ausgegeben wird, wenn das Ergebnissignal nicht mit einem erwarteten Ergebnissignal übereinstimmt.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert ist und zur Durchführung des Verfahrens nach einem der vorstehend beschriebenen Ausführungsformen verwendet wird, wenn das Programm auf der genannten Vorrichtung ausgeführt wird.

Die vorliegende Erfindung bietet den Vorteil, dass gegenüber den vorstehend genannten Methoden 2) oder 4) kein eigener (Hardware-) Anschluss für die Ein- oder Ausgabe eines zweiten Taktes erforderlich ist. Gegenüber der vorstehend beschriebenen Methode 3) wird ebenfalls kein weiterer Eingang und kein weiteres Bauelement, wie z. B. ein Oszillator benötigt. Bei Methoden 1) und 4) wird die Frequenzüberwachung von einem externen Rechner, wie z. B. einem Mikrokontroller (µC), einer zusätzlichen Schaltung (ASIC) oder einem entsprechenden Kontroller übernommen, was erhöhten Rechenaufwand bedeutet und technisch höhere Anforderungen an den Nutzer des Sensors stellt und zusätzliche Applikationen erfordert.

Zusammenfassend kann somit gesagt werden, dass wichtige Vorteile des erfindungsgemäßen Konzeptes darin zu sehen sind, dass keine zusätzlichen PINs oder Anschlüsse am Sensor für die Frequenzüberwachung benötigt werden, keine zusätzlichen Anforderungen an den Nutzer des Sensors gestellt werden, da eine Kommunikationsschnittstelle bereits vorhanden ist, keine weiteren oder zusätzlichen Bausteine (wie z. B. ein Quarz) notwendig sind und eine Implementierung der Frequenzüberwachung beispielsweise auch sensorintern oder intern zu einer anderen separaten Einheit stattfinden kann und so kein Aufwand für zusätzliche Applikationen besteht.

Günstig ist es, wenn ferner ein Schritt des Ausgebens eines Kontrollsignals über eine Signalleitung der Kommunikationsschnittstelle erfolgt, wenn die erkannte Qualität des Frequenzsignals ein definiertes Kriterium erfüllt. Eine derartige Ausführungsform der Erfindung bietet den Vorteil, dass auch bei einer in der Einheit intern erkannten fehlerhaften internen Taktfrequenz eine entsprechende Signalisierung an eine zweite Einheit (beispielsweise eine Master- oder Steuereinheit) ausgegeben werden kann. Das vorgegebene Kriterium kann dabei beispielsweise ein erwarteter Zählerstand sein, von dem ein Zählerstand, der durch das interne Frequenzsignal gesteuert wird, nicht mehr als um einen vorgegebenen Toleranzbereich abweicht. Die Signalisierung des Fehlerhaften internen Frequenzsignals kann dabei ebenfalls über die Signalleitungen der Kommunikationsschnittstelle erfolgen, so dass wiederum kein separater Pin für dieses Signal vorzusehen ist.

In einer anderen Ausführungsform kann ferner im Schritt des Vergleichens ein zweiter Zähler von dem Steuersignal und dem Signalpegel des von der Kommunikationsschnittstelle empfangenen Taktsignals gesteuert werden, um einen zweiten Zählerstand zu erhalten, wobei im Schritt des Erkennens die vorbestimmte Qualität erkannt werden kann, wenn der zweite Zählerstand in einem Wertebereich liegt, der höchstens um einen vordefinierten Toleranzwert von dem Zählerstand des Zählers abweicht. Eine solche Ausführungsform der Erfindung bietet den Vorteil, dass nicht nur eine kontinuierliche Überwachung des Frequenzsignals möglich ist, sondern auch eine Überwachung in Zeitintervallen. Während dieser Zeitintervalle läuft dann ein Zähler, so dass nach Ablauf der Zeitdauer des Zeitintervalls der Zählerstand mit einem erwarteten Zählerstand verglichen werden kann, der erreicht werden müsste, wenn das interne Frequenzsignal fehlerfrei ist.

Um insbesondere Sensoren zuverlässig überwachen zu können, die oftmals sehr sicherheitskritische Sensordaten aufnehmen müssen, kann auch in einer speziellen Ausführungsform der Erfindung die Einheit ein Sensor sein, wobei das Verfahren ferner einen Schritt des Übertragens eines eine physikalische Größe repräsentierenden Messsignals über eine Signalleitung der Kommunikationsschnittstelle umfassen kann. Eine derartige Ausführungsform der vorliegenden Erfindung bietet den Vorteil, dass eine Sensoreinheit angeschlossen werden und das mittels der Sensoreinheit erzeugte Messsignal zu einer weiteren Verarbeitung über eine Bussignalleitung übertragen werden kann. Dies ermöglicht eine sehr zuverlässige Bereitstellung des Messsignals, das unter Verwendung des präzise überwachten Frequenzsignals erzeugt wurde.

Um insbesondere bereits gut erprobte und oftmals in Anwendungsumgebungen für die Erfindung bereits vorhandene Komrnunikationsstränge verwenden zu können, kann im Schritt des Empfangens ein Empfang von Daten über die Signalleitungen der Kommunikationsschnittstelle entsprechend einem standardisierten Kommunikationsprotokoll, insbesondere einem SPI-, CAN- , PS15, FlexRay- oder einem anderen Busprotokoll, erfolgen. Eine derartige Ausführungsform der vorliegenden Erfindung bietet den Vorteil, dass ein standardisiertes Busprotokoll teilweise Routine beinhalten kann, um die Buskommunikationsschnittstelle auf ihre Betriebsfähigkeit hin zu testen. Insbesondere erlaubt eine Anpassung der Übertragung von Daten gemäß einem standardisierten Busprotokoll eine Auswahl von im Einsatz befindlichen Busprotokollen, wie z. B. SPI-, CAN-, FlexRay- oder einem PS15-Busprotokoll.

Um auch die Gewinnung des externen Taktsignals zu erleichtern, so dass keine separate Taktleitung in der Kommunikationsschnittstelle bereitgestellt werden zu braucht, kann im Schritt des Empfangens ein Erzeugen des Taktsignals aus Signalflankenänderungen von zumindest einem Signal erfolgen, das zusätzlich zur Taktinformation zumindest eine weitere Dateninformation enthält. Beispielsweise kann auf diese Art auch aus Signalen, die zur Datenübertragung über die Kommunikationsschnittstelle vorgesehen sind, ein Taktsignal für die Überprüfung des internen Frequenzsignals erzeugt werden. Dies bietet den Vorteil, dass eine kleinere Kommunikationsschnittstelle mit einer geringeren Anzahl von Pins verwendet werden kann, um dennoch das Frequenzsignal überprüfen zu können, das in der Einheit erzeugt wurde.

Die Erfindung wird anhand der beigefügten Zeichnungen beispielhaft näher erläutert. Es zeigen:
- Fig. 1: ein Blockschaltbild eines Ausführungsbeispiels;
- Fig. 2: ein Blockschaltbild eines weiteren Ausführungsbeispiels;
- Fig. 3: ein Blockschaltbild eines anderen Ausführungsbeispiels;
- Fig. 4: ein Blockschaltbild eines zusätzlichen Ausführungsbeispiels;
- Fig. 5: ein Blockschaltbild einer Master-Slave-Anordnung;
- Fig. 6: ein Blockschaltbild eines ersten Ausführungsbeispiels gemäß der vorliegenden Erfindung;
- Fig. 7: ein Blockschaltbild eines weiteren Ausführungsbeispiels gemäß vorliegenden Erfindung;
- Fig. 8: ein Blockschaltbild eines zusätzlichen Ausführungsbeispiels gemäß vorliegenden Erfindung; und
- Fig. 9: ein Ablaufdiagramm eines Ausführungsbeispiels der Erfindung als Verfahren.

Gleiche oder ähnliche Elemente können in den Figuren durch gleiche oder ähnliche Bezugszeichen versehen sein, wobei auf eine wiederholte Beschreibung verzichtet wird. Ferner enthalten die Figuren der Zeichnungen, deren Beschreibung sowie die Ansprüche zahlreiche Merkmale in Kombination. Einem Fachmann ist dabei klar, dass diese Merkmale auch einzeln betrachtet werden oder sie zu weiteren, hier nicht explizit beschriebenen Kombinationen zusammengefasst werden können. Ferner können erfindungsgemäße Verfahrensschritte wiederholt sowie in einer anderen als in der beschriebenen Reihenfolge ausgeführt werden. Umfasst ein Ausführungsbeispiel eine "und/oder" Verknüpfung zwischen einem ersten Merkmal/Schritt und einem zweites Merkmal/Schritt, so kann dies so gelesen werden, dass das Ausführungsbeispiel gemäß einer Ausführungsform sowohl das erste Merkmal / den ersten Schritt als auch das zweite Merkmal /den zweiten Schritt und gemäß einer weiteren Ausführungsform entweder nur das erste Merkmal /Schritt oder nur das zweite Merkmal /Schritt aufweist.

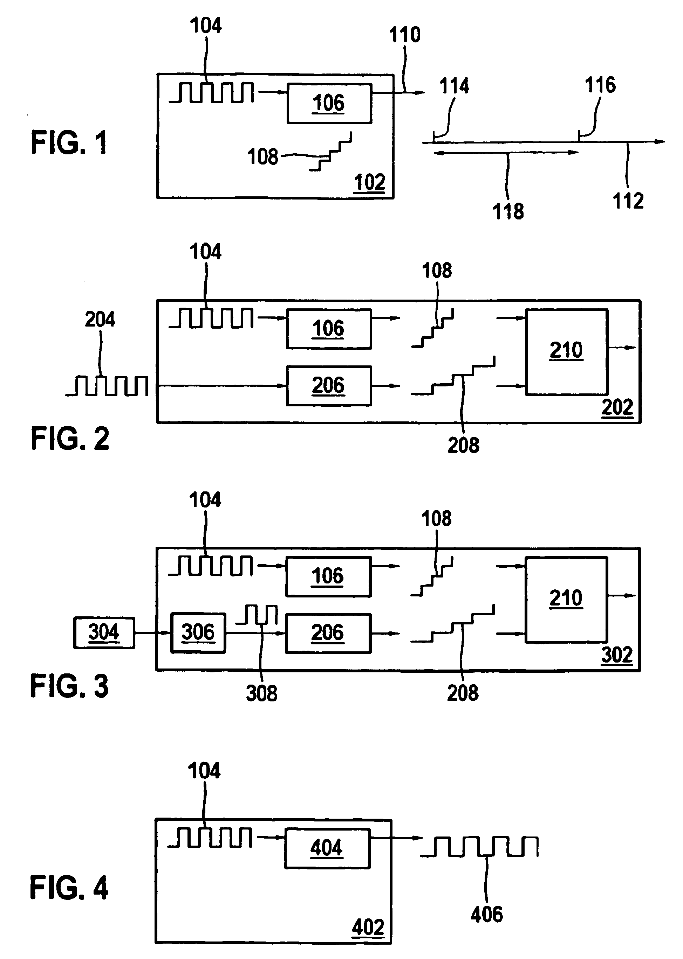

Fig. 1 zeigt einen Sensor 102, der einen Zähler 106 umfasst. Ein innerhalb des Sensors 102 erzeugter Takt 104 wird in den Zähler 106 eingespeist. Der interne Takt 104 bewirkt im Zähler 106 eine diskrete, stufenweise Erhöhung des Zählerstands, was symbolisch durch eine Treppenstufenfunktion 108 dargestellt ist. Über eine SPI-Schnittstelle 110 kann der Zählerstand am Ausgang des Zählers 106 abgegriffen werden. Anhand einer Zeitachse 112 wird das Verfahren zur Frequenzermittlung verdeutlicht. Dazu wird zu einem ersten Zeitpunkt 114 ein Zählerstand I und zu einem späteren Zeitpunkt 116 ein Zählerstand II über die SPI-Schnittstelle 110 bestimmt und abgespeichert. Aus einer gebildeten Differenz aus dem Zählerstand I und dem Zählerstand II wird ein ein Zählerstandunterschied bestimmt. Wird zwischen dem ersten Zeitpunkt 114 und dem späteren Zeitpunkt 116 eine fest vorgegebene Zeitperiode 118 gewählt, so lässt sich die Frequenz aus dem Zählerstandunterschied pro Zeitperiode 118 sehr einfach bestimmen.

Fig. 2 zeigt einen Sensor 202, der ähnlich zu dem Sensor 102 aus Fig. 1 aufgebaut ist, wobei jedoch gegenüber dem Sensor aus Fig. 1 nun ein zweiter Zähler 206 innerhalb des Sensors 202 angeordnet ist, der von einem externen Takt 204 gespeist wird. Sowohl der Zählerstand des ersten Zählers 106 als auch der Zählerstand des zweiten Zählers 206 werden den internen Takt 104 bzw. den externen Takt 204 erhöht, was durch die Treppenstufenfunktion 108, 208 symbolisch dargestellt ist. Die Zählerstände werden jeweils am Ausgang der entsprechenden Zähler bereitgestellt. Dabei wird der Ausgang des ersten Zählers 106 und der Ausgang des zweiten Zählers 206 direkt den die verschiedenen Eingänge einer Vergleichseinheit 210 zugeführt, die innerhalb des Sensors 102 angeordnet ist. Das Signal am Ausgang der Vergleichseinheit 210 kann abgegriffen und abhängig vom Signalwert des Signals entschieden werden, ob der interne Takt 104 dem externen Takt 204 als einem Referenztakt entspricht.

Fig. 3 zeigt einen Sensor 302, der ähnlich dem Sensor aus Fig. 2 aufgebaut ist, wobei jedoch der zweite Zähler 206 von einer PLL-Einheit 306 gespeist wird und innerhalb des Sensors 302 angeordnet ist. Ein Quarzelement 304 erzeugt ein zeitlich periodisches elektrisches Signal, das mittels der PLL-Einheit 306 in einen Referenztakt 308 konvertiert und dem zweiten Zähler 206 zugeführt wird. Bei jedem Takt, beispielsweise bei jeder steigenden Taktflanke sowohl des internen Takt s104 als auch des Referenztaktes 308, wird der Zählerstand des ersten Zählers 106 bzw. zweiten Zähler 206 diskret erhöht, was über die dargestellten Treppenstufenfunktionen 108, 208 verdeutlicht wird. Die Ausgänge der beiden Zähler 106, 206 werden unterschiedlichen Eingängen einer Vergleichseinheit 210 zugeführt. Ein Vergleich der beiden Zählerstände über die Vergleichseinheit 210 ergibt ein Signal am Ausgang der Vergleichseinheit 210, wobei abhängig vom Signalwert eine Entscheidung für eine Gleichheit zwischen dem internen Takt 104 und dem Referenztakt 308 getroffen werden kann.

Fig. 4 zeigt einen Sensor 402, der einen Konverter 404 umfasst, der von einem internen Takt 104 gespeist wird. Am Ausgang des Konverters kann ein Signal 406 abgegriffen werden, das den internen Takt repräsentiert. Das Signal am Taktausgang 406 kann an einen externen Rechner übertragen und aus dem übertragenen Taktsignal eine Frequenz ermittelt werden.

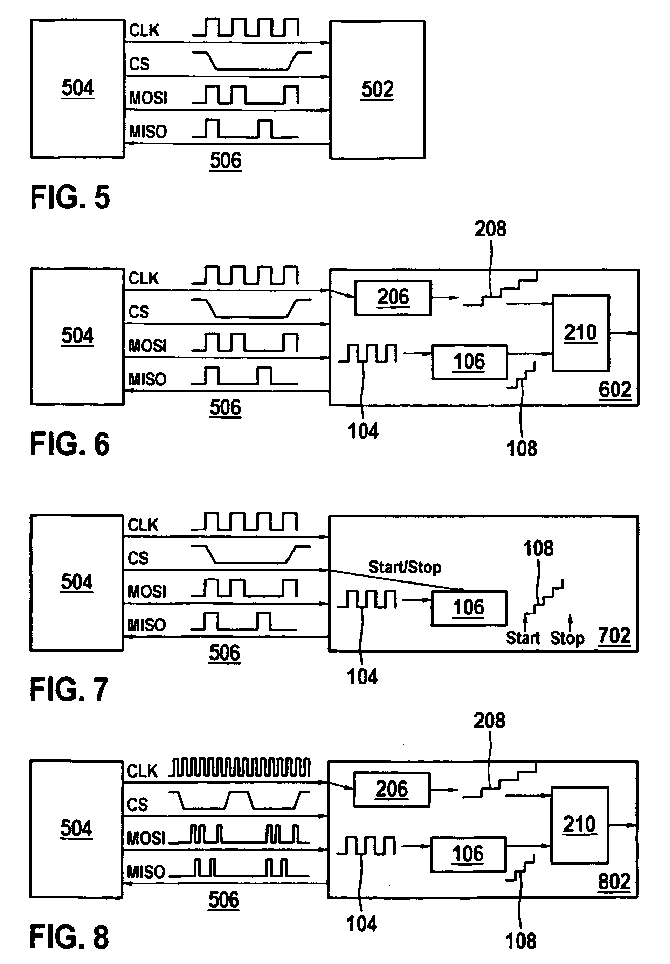

Fig. 5 zeigt eine Anordnung von einer Mastereinheit 504, die beispielsweise ein Mikrocontroller sein kann, und einer Slaveeinheit 502, die beispielsweise eine Sensoreinheit sein kann. Die Mastereinheit 504 ist über eine Mehrzahl von Bussignalleitungen 506 mit der Slaveeinheit 502 verbunden. Ein von der Mastereinheit 504 erzeugtes oder bereitgestelltes und über eine Bussignalleitung übertragenes CLK-Signal wird als ein Taktsignal für die Slaveeinheit 502 verwendet. Über ein CS-Signal wird die Slaveeinheit 502 aktiviert. Eine Kommunikation oder ein Datenaustausch zwischen der Mastereinheit 504 und der Slaveeinheit 502 findet über einen MOSI-Kanal und einem MISO-Kanal der Bussignalleitungen statt.

Die in den Figuren 1 bis 4 dargestellten Ansätze beruhen darauf, die ermittelte Taktfrequenz des Sensors mit einer zweiten Frequenz zu vergleichen. In Fig. 1 läuft ein sensorintemer Zähler 106 mit dem sensorinternen Takt 104. Mit speziellen Abfragen zu den Zeitpunkten 114 und 116 über die Schnittstelle 110 zum Sensor kann der aktuelle interne Zählerstand des ersten Zählers 106 ausgelesen werden. Durch Kenntnis der Zeitpunkte 114 und 116 zu denen der Zählerstand des ersten Zählers 106 ausgelesen wurde, die insbesondere die Zeitpunkte der Abfragen definieren , kann die Zählgeschwindigkeit des sensorinternen Zählers, welche direkt abhängig von der sensorinternen Taktfrequenz 104 ist, in Relation zur Zeitdifferenz 118 der beiden Abfragezeitpunkte gesetzt werden. Die Abfragezeitpunkte werden durch einen, in der Regel vom internen Takt unabhängigen Takt festgelegt. Durch die Relation der Zeitdauer 118 zwischen den beiden Abfragezeitpunkten 114 und 116 mit dem zu erwartenden Zählerstand kann der sensorinteme Takt104 redundant überwacht werden. In Fig. 2 ist zusätzlich zu den Elementen aus Fig. 1 ein weiterer Zähler 206 im Einsatz, der von einem externen Takt 204 gespeist wird. Der auf dem Ausgang des Zählers 106 ausgegebene Zählerstand 108 kann mittels einer Vergleichseinheit 210 mit Zählerständen 208 aus weiteren Zählern 206 verglichen werden. Das in Fig. 3 dargestellte Konzept unterscheidet sich von dem Konzept aus Fig. 2 nur dahingehend, dass in Fig. 3 aus einem externen Oszillator oder Quarz 304 erst ein zweiter Takt 308 über eine PLL-Einheit 306 sensorintern generiert wird. Dieser zweite, von außen eingespeiste 204 oder intern generierte Takt 304 kann mit dem eigentlichen Systemtakt 104 verglichen werden. Der Vergleich wird dadurch realisiert, dass zwei Zähler 106 und 206, ein erster Zähler 106, beruhend auf dem internen Takt 104, und ein zweiter Zähler 206, beruhend auf dem externen Takt 204 oder 304, beispielsweise mit jeder steigenden Taktflanke erhöht werden. Nach einer gewissen Zeit, d.h. wenn ein Zähler zum Beispiel einen bestimmten Wert erreicht hat werden die beiden Zählerstände 108 und 208 verglichen. Dadurch kann der interne Systemtakt 104 mit einem zweiten redundanten Takt 204 oder 304 verglichen werden. Der in Fig. 4 dargestellte Ansatz unterscheidet sich von dem in Fig.2 dargestellten Ansatz dahingehend, dass der sensorinterne Takt 104 nach außen geführt wird und ein externer Rechner, wie beispielsweise ein Microcontroller, ein ASIC oder ein anderer Controller diesen Takt 406 mit seinem eigenen Takt vergleichen muss und dieser Vergleich und die externe Bewertung nicht sensorintern stattfindet. Weiterhin haben die meisten Sensoren eine digitale Schnittstelle. Eine mögliche Ausprägung einer solchen Schnittstelle ist eine SPI (Serial Peripheral Interface)-Schnittstelle, die in Fig. 5 schematisch dargestellt ist. Eine solche Schnittstelle umfasst vier Leitungen 506 , die als CS, MISO, MOSI und CLK bezeichnet werden. Während über die Chip-Select-Leitung (CS) eine Slaveeinheit 502 durch den Master 504 aktiviert wird, werden auf der Taktleitung (CLK) durch den Master 504 bereitgestellte Takte ausgegeben und Daten zu verschiedenen Taktflanken über den Datenausgang gesendet (MOSI). Der Slave 506 kann auf seiner Datenausgangsleitung (MISO) synchron zum Takt Daten an den Master 504 senden. Die Anzahl der Takte und das genaue Timing ist von Protokoll zu Protokoll unterschiedlich.

Sensoren werden normalerweise in einer Slave-Konfiguration an der SPI-Schnittstelle angeschlossen. Ein wichtiges Merkmal eines besonderen Ausführungsbeispiels der Erfindung, das in dem folgend beschrieben Ansatz ausgenutzt wird, besteht darin, dass der Takt der CLK-Leitung genauso wie der Takt aus der Frequenzüberwachung von einem unabhängigen Taktgenerator erzeugt wird und eine hohe Taktgenauigkeit aufweist. Ebenso sind die Flanken der CS-Leitung meistens deterministisch durch den Takt des Masters bestimmt.

Fig. 6 zeigt ein Blockschaltbild einer Slaveeinheit 602, die über eine Mehrzahl von Bussignalleitungen 506 mit einer Mastereinheit 504 verbunden ist. Ein CS-Signal, das über eine Bussignalleitung übertragen wird, steuert einen Zähler 206 an, der innerhalb der Slaveeinheit 602 angeordnet ist, wobei am Ausgang des Zählers 206 ein Zählerstand ausgegeben werden kann. Während der Ansteuerung des Zählers 206 mittels des CS-Signals findet eine Zählerstanderhöhung pro einer Taktperiode des CLK-Signals statt. Eine symbolhafte Darstellung der Zählerstanderhöhung zeigt eine Treppenstufenfunktion 208. Ein interner Takt 104 wird dem Zähler 106 zugeführt und ein Signal am Ausgang des Zählers 106 bereitgestellt wird. Das Signal entspricht einem Zählerstand und die diskrete Erhöhung des Zählerstandes kann durch die Treppenstufenfunktion 108 dargestellt werden. Der Ausgang des Zählers 106 und der Ausgang des Zählers 206 werden unterschiedlichen Eingängen einer Vergleichseinheit 210 zugeführt. Am Ausgang der Vergleichseinheit 210 kann ein Signal abgegriffen werden. Abhängig vom Signalwert kann entschieden werden, ob der interne Takt 104 dem Takt des CLK-Signals entspricht. Zusätzlich können über die Bussignalleitungen MOSI und MISO Daten zwischen der Mastereinheit 504 und der Slaveeinheit 602 ausgetauscht werden. Beispielsweise wird ein Signal als Ausgangssignal über die MISO-Bussignalleitung übertragen, das ein Vergleichsergebnis des Vergleichers 210 repräsentiert. Dadurch wird dem Master 504 eine Information über das Vergleichsergebnis mitgeteilt, um auf diese Weise die Überwachung des internen Taktes vom Master 504 aus zu kontrollieren.

Fig. 7 zeigt eine Mastereinheit 504, die über eine Mehrzahl von Bussignalleitung 506 mit einer Slaveeinheit 702 verbunden ist. Die Slaveeinheit 702 umfasst einen Zähler 106, der über einen internen Takt 104 angesteuert wird. Ein am Ausgang des Zählers 106 bereitgestellter Zählerstand wird ansprechend auf Flanken des internen Taktsignals 104 diskret erhöht. Eine diskrete Erhöhung des Zählerstandes des Zählers 106 wird durch eine Treppenstufenfunktion 108 dargestellt. Zusätzlich ist die CS-Bussignalleitung mit dem Zähler 106 verbunden, um eine Start und Stopfunktion für den Zähler 106 zu ermöglichen. Bei einem entsprechenden Signal, d.h. ansprechend auf eine Signalflanke oder einen Pegel des Signalsauf der CS-Bussignalleitung (das ein Startkriterium für den Zähler 106 dient) wird der Zähler 106 gestartet und zuvor ein entsprechender Startzählerstand abgespeichert. Analog wird bei einem Signal auf der CS-Bussignalleitung, d.h. ansprechend auf eine Signalflanke oder einen Pegel des Signals auf der CS-Bussignalleitung als Stoppkriterium, der Zähler 106 gestoppt und zuvor ein entsprechender Endzählerstand abgespeichert. Aus dem Endzählerstand und dem Startzählerstand wird ein Zählerstandunterschied ermittelt. Ferner werden über die Bussignalleitungen MOSI und MISO Daten mit einer durch das CLK-Signal vorgegeben Taktrate zwischen der Mastereinheit 504 und der Slaveeinheit 702 ausgetauscht werden. Beispielsweise wird ein Signal als Ausgangssignal über die MISO-Bussignalleitung an den Master 504 übertragen, das ein Vergleichsergebnis des Vergleichers 210 repräsentiert. Dadurch wird dem Master 504 eine Information über das Vergleichsergebnis mitgeteilt, um auf diese Weise die Überwachung des internen Taktes vom Master 504 aus zu kontrollieren.

Fig. 8 zeigt eine Darstellung eines weiteren Ausführungsbeispiel der Erfindung, wobei eine Slaveeinheit 802 in Fig. 7 dargestellt ist, die eine Aufbau ähnlich zu Fig. 6 aufweist. Die Slaveeinheit 802 ist über ein Bussystem, bestehend aus einer Mehrzahl von Bussignalleitung 506, mit einer Mastereinheit 504 verbunden. Die einzelnen Bussignalleitungen übertragen Signale wie z.B. ein Bustaktsignal (CLK), ein Signal zur Auswahl und Aktivierung von einer aus mehreren Slaveeinheiten (CS), und Signale (MOSI und/oder MISO), die eine Kommunikation zwischen der Mastereinheit 504 und der Slaveeinheit 802 ermöglichen. Innerhalb der Slaveeinheit 802 ist ein erster Zähler 106 und ein zweiter Zähler 206 angeordnet, wobei ein Ausgang des ersten Zählers 106 und ein Ausgang des zweiten Zählers 206 mit unterschiedlichen Eingängen einer Vergleichseinheit 210 verbunden sind. Die Vergleichseinheit 210 ist innerhalb der Slaveeinheit 802 angeordnet. Ein interner Takt 104 steuert den ersten Zähler 106, in dem ein Zählerstand des ersten Zählers 106 an einem ersten Eingang der Vergleichseinheit 210 bereitgestellt wird, wobei der Zählerstand des Zählers 106 während eines Taktzyklus des internen Taktes 104 erhöht wird. Eine solche Erhöhung ist beispielhaft durch eine Treppenstufenfunktion 108 dargestellt. Eine Verknüpfung von Signalen einzelner Bussignalleitungen (beispielsweise die Verknüpfung der Signals CLK und CS) bildet ein Taktsignal für den Eingang des zweiten Zählers 206, wobei ein Zählerstand des zweiten Zählers 206 während eines Taktzyklus des Taktsignals erhöht wird. Eine solche Erhöhung des Zählerstandes ist beispielhaft durch eine Treppenstufenfunktion 208 dargestellt. Der Zählerstand des zweiten Zählers 206 wird an einem zweiten Eingang der Vergleichseinheit 210 bereitgestellt. An einem Ausgang der Vergleichseinheit 210 wird ein Ausgangssignal abgegriffen, wobei sich ein Wert des Ausgangsignals ergibt, abhängig davon, ob der Zählerstand des internen Taktes 104 dem Zählerstand des Taktsignals entspricht. Zusätzlich kann über das CS-Signal eine Slaveeinheit aus einer Mehrzahl von Slaveeinheiten aktiviert werden. Beispielsweise wird ein Signal als Ausgangssignal über die MISO-Bussignalleitung an den Master 504 übertragen, das ein Vergleichsergebnis des Vergleichers 210 repräsentiert. Dadurch wird dem Master 504 eine Information über das Vergleichsergebnis mitgeteilt, um auf diese Weise die Überwachung des internen Taktes vom Master 504 aus zu kontrollieren.

Anstatt der aktuell im Stand der Technik genutzten Frequenzüberwachungsmöglichkeiten könnte auch eine oder mehrere der SPI-Leitungen dazu genutzt werden, den internen Sensortakt gegen einen weiteren Takt zu vergleichen. Entweder könnte ein sensorintemer Zähler aufgrund des SPI-Taktes erhöht werden (so wie es in dem in Fig. 6 dargestellten Ansatz beschrieben ist) und mit einem Zählerstand, der ansprechend auf den sensorinternen Takt erhöht wird, verglichen werden. Oder es könnte die Aktivierung des CS-Signals entsprechen dem in Fig. 7 dargestellten Ansatz dazu genutzt werden, einen Zählerstand eines Zählers mit dem internen Takt zu erhöhen, wobei die Deaktivierung des CS-Signals dazu genutzt werden kann den Zählerstand dieses Zählers "einzufrieren" und den eingefrorenen" Zäherlstand gegen einen Sollwert zu vergleichen.

Folgende Erweiterungen, Detaillierungen oder Abwandlungen sind weiterhin denkbar:

Da es im normalen Sensorbetrieb regelmäßig zu SPI-Kommunikation kommt, könnte die Überwachung sehr hohe zeitliche Überwachungsdeckung erreichen. Zusätzlich könnte eine Überwachung eingebaut werden, die prüft ob überhaupt und wenn ja, mit welcher Häufigkeit SPI-Kommunikation stattfindet und somit die erfindungsgemäße Überwachung möglich ist und eine zeitlich hohe Deckung erreicht.

Um eine maximale zeitliche Abdeckung zu erreichen wäre es möglich, den Takt der SPI auch zu senden während keine Kommunikation über die MISO- und MOSI-Busdatenleitungen stattfindet. Der Sensor würde in diesem Fall die Kommunikation wie bisher aufnehmen, wenn ein entsprechender CS-Pegel angesteuert wird. Für diesen Fall würde der Master, während der Phasen in denen keine Kommunikation stattfindet, Takte zu senden.

Eine sensor- und kommunikationsspezifische Abwandlung könnte darin bestehen, zum Beispiel nur einen Teil des SPI-Taktes (d.h. des Bustaktes), wie beispielsweise die ersten 8 Takte oder eine Kombination von SPI-Takten und CS Signalflanken zu nutzen. Eine weitere Option ist es auch, die Datenleitungen zu nutzen, um aus den Flanken der Datenleitungen einen Takt zu erzeugen mit dem ein Zähler gesteuert wird der gegen einen Zähler mit internem Takt verglichen werden kann.

Die Erfindung lässt sich natürlich nicht nur mit SPI-Schnittstellen umsetzten sondern auch mit diversen anderen Schnittstellen von denen ein unabhängiger Takt abgeleitet oder eine zeitkonstante Triggerung möglich ist, wie z. B. mit einem Can, FlexRay oder PS15.

Der hier vorgestellte Ansatz zur Überwachung eines Frequenzsignals könnte auf jeden SPI-Befehl oder nur auf spezielle Befehle oder nur nach vorangegangener Aktivierung angewandt werden.

Der hier vorgestellte Ansatz der Frequenzüberwachung kann natürlich auch für jedes andere System angewendet werden, wie z. B. ein Mikrocontroller oder ASICs, das auf einen exakten Takt angewiesen ist und mit einer Schnittstelle ausgerüstet ist, die den hier vorgestellten Ansatz zur Überwachung zulässt.

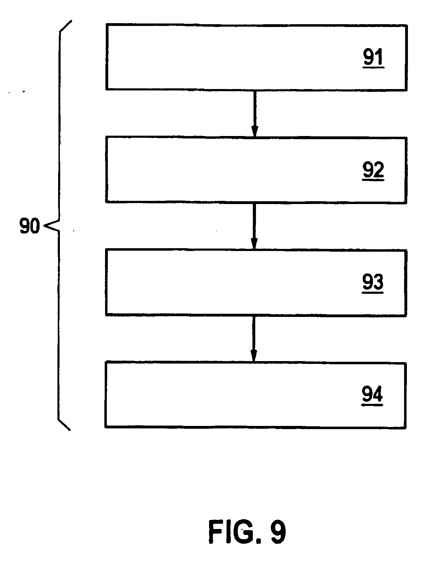

Fig. 9 zeigt ein Ablaufdiagramm eines Verfahrens 90 zur Überwachung eines Frequenzsignals, das innerhalb einer Einheit bereitgestellt wird. Das Verfahren 90 umfasst dabei einen Schritt des Empfangens 91 eines oder mehrerer binärer Signalpegel eines Taktsignals oder eines Steuersignals von einer Kommunikationsschnittstelle, wobei die Kommunikationsschnittstelle ausgebildet ist, um Informationen entsprechend einem Kommunikationsprotokoll zu übertragen. Weiterhin umfasst das Verfahren 90 einen Schritt des Bereitstellens 92 des Frequenzsignals in der Einheit sowie einen Schritt des Vergleichens 93 des Frequenzsignals mit einer zeitlichen Folge von Signalpegeln des von der Kommunikationsschnittstelle empfangenen Taktsignals, um ein Vergleichsergebnis zu erhalten oder Steuern eines Zählers durch das Steuersignal und das Frequenzsignal, um einen Zählerstand zu erhalten. Schließlich umfasst das Verfahren 90 einen Schritt des Erkennens 94 einer vorbestimmten Qualität des Frequenzsignals, wenn das Vergleichsergebnis ein vorbestimmtes Kriterium erfüllt oder wenn der Zählerstand innerhalb eines vorbestimmten Wertebereiches liegt, um durch die erkannte Qualität des Frequenzsignals dieses zu überwachen.

## Patentansprüche

1. Verfahren (90) zur Überwachung eines Frequenzsignals (104), das inner-halb einer Einheit (102) bereitgestellt wird, wobei das Verfahren die folgenden Schritte aufweist:
- Empfangen (91) eines oder mehrerer binärer Signalpegel eines Taktsignals (CLK) oder eines Steuersignals (CS) von einer Kommunikationsschnittstelle (CLK, CS, MOSI, MISO), wobei die Kommunikationsschnittstelle (CLK, CS, MOSI, ausgebildet ist, um Informationen entsprechend einem Kommunikationsprotokoll zu übertragen;
- Bereitstellen (92) des Frequenzsignals (104) in der Einheit;
- Vergleichen (93) des Frequenzsignals (104) mit einer zeitlichen Folge von Signalpegeln des von der Kommunikationsschnittstelle (CLK, CS, MOSI, MISO) empfangenen Taktsignals (CLK), um ein Vergleichsergebnis zu erhalten oder Steuern eines Zählers (106) durch das Steuersignal (CS) und das Frequenzsignal (104), um einen Zählerstand zu erhalten; und
- Erkennen (94) einer vorbestimmten Qualität des Frequenzsignals (104), wenn das Vergleichsergebnis ein vorbestimmtes Kriterium erfüllt oder wenn der Zählerstand innerhalb eines vorbestimmten Wertebereiches liegt, um durch die erkannte Qualität des Frequenzsignals (104) dieses zu überwachen.

2. Verfahren (90) gemäß Anspruch 1, **dadurch gekennzeichnet, dass** ferner ein Schritt des Ausgebens eines Kontrollsignals (MISO) über eine Signalleitung der Kommunikationsschnittstelle (CLK, CS, MOSI, MISO) erfolgt, wenn die erkannte Qualität des Frequenzsignal (104) ein definiertes Kriterium erfüllt.

3. Verfahren (90) gemäß einem der vorangegangenen Ansprüche, **dadurch gekennzeichnet, dass** ferner im Schritt des Vergleichens ein zweiter Zähler (206) von dem Steuersignal (CS) und dem Signalpegel des von der Kommunikationsschnittstelle (CLK, CS, MOSI, MISO) empfangenen Taktsignals (CLK) gesteuert wird, um einen zweiten Zählerstand zu erhalten, wobei im Schritt des Erkennens die vorbestimmte Qualität erkannt wird, wenn der zweite Zählerstand in einem Wertebereich liegt, der höchstens um einen vordefinierten Toleranzwert von dem Zählerstand des Zählers (106) abweicht.

4. Verfahren (90) gemäß einem der vorangegangenen Ansprüche, **dadurch gekennzeichnet, dass** die Einheit (102) ein Sensor ist, wobei das Verfahren (90) ferner einen Schritt des Übertragens eines eine physikalische Größe repräsentierenden Messsignals über eine Signalleitung (MISO) der Kommunikationsschnittstelle (CLK, CS, MOSI, MISO) umfasst.

5. Verfahrens gemäß einem der vorangegangenen Ansprüche, **dadurch gekennzeichnet, dass** im Schritt des Empfangens (91) ein Empfang von Daten über die Signalleitungen der Kommunikationsschnittstelle (CLK, CS, MOSI, MISO) entsprechend einem standardisierten Kommunikationsprotokoll, insbesondere einem SPI-, CAN- FlexRay- oder einem PSIS-Busprotokoll, erfolgen.

6. Verfahren gemäß einem der vorangegangenen Ansprüche, **dadurch gekennzeichnet, dass** im Schritt des Empfangens (91) ein Erzeugen des Taktsignals (CLK) aus Signalflankenänderungen von zumindest einem Signal (CS, MOSI) erfolgt, das zusätzlich zur Taktinformation zumindest eine weitere Dateninformation enthält.

7. Vorrichtung (602, 702, 802), die ausgebildet ist, um die Schritte eines Verfahrens (90) gemäß einem vorangegangenen Ansprüche auszuführen.

8. Computerprogrammprodukt mit Programmcode, der auf einem maschinenlesbaren Träger gespeichert ist, zur Durchführung des Verfahrens (90) nach einem der Ansprüche 1 bis 6, wenn das Computerprogrammprodukt auf einer Vorrichtung (602, 702, 802) ausgeführt wird.

9. Überwachungsvorrichtung (502, 602, 702, 802) zur Überwachung eines Frequenzsignals (104), wobei die Überwachungsvorrichtung folgende Merkmale aufweist:
- eine Vorrichtung (602, 702, 802) gemäß Anspruch 7;
- ein Busübertragungssystem, das mit der Kommunikationsschnittstelle (CLK, CS, MOSI, MISO) der Vorrichtung (602, 702, 802) verbunden ist und zur Datenübertragung von der Vorrichtung (fi02, 702, 802) zu einer Steuereinheit (502) ausgebildet ist;
- die Steuereinheit (502), die zur Ausgabe eines Taktsignals (CLK) oder eines Steuersignals (CS) zur Aktivierung der Vorrichtung (602, 702, 802) ausgebildet ist, wobei die Steuereinheit ferner ausgebildet ist, um eine Überwachung des Frequenzsignals (104) derart auszuführen, dass ein Fehlerwamsignal ausgegeben wird, wenn das Ergebnissignal nicht mit einem erwarteten Ergebnissignal übereinstimmt.

## Claims

1. Method (90) for monitoring a frequency signal (104) which is provided within a unit (102), wherein the method has the following steps:
- one or more binary signal levels of a clock signal (CLK) or of a control signal (CS) is/are received (91) from a communication interface (CLK, CS, MOSI, MISO), wherein the communication interface (CLK, CS, MOSI, MISO) is designed to transmit information on the basis of a communication protocol;
- the frequency signal (104) is provided (92) in the unit;
- the frequency signal (104) is compared (93) with a chronological sequence of signal levels of the clock signal (CLK) received from the communication interface (CLK, CS, MOSI, MISO) in order to obtain a comparison result, or a counter (106) is controlled by the control signal (CS) and the frequency signal (104) in order to obtain a counter reading; and
- a predetermined quality of the frequency signal (104) is identified (94) if the comparison result satisfies a predetermined criterion or if the counter reading is within a predetermined range of values in order to use the identified quality of the frequency signal (104) to monitor the latter.

2. Method (90) according to Claim 1, **characterized in that** also a step of outputting a supervisory signal (MISO) via a signal line of the communication interface (CLK, CS, MOSI, MISO) takes place if the identified quality of the frequency signal (104) satisfies a defined criterion.

3. Method (90) according to one of the preceding claims, **characterized in that** also the step of comparison involves a second counter (206) being controlled by the control signal (CS) and the signal level of the clock signal (CLK) received from the communication interface (CLK, CS, MOSI, MISO) in order to obtain a second counter reading, wherein the step of identification involves the predetermined quality being identified if the second counter reading is in a range of values which differs from the counter reading of the counter (106) by no more than a predefined tolerance value.

4. Method (90) according to one of the preceding claims, **characterized in that** the unit (102) is a sensor, wherein the method (90) also comprises a step of transmitting a measurement signal which represents a physical variable via a signal line (MISO) of the communication interface (CLK, CS, MOSI, MISO).

5. Method according to one of the preceding claims, **characterized in that** the step of receiving (91) involves receiving data via the signal lines of the communication interface (CLK, CS, MOSI, MISO) on the basis of a standardized communication protocol, particularly an SPI, CAN, FlexRay or PSI5 bus protocol.

6. Method according to one of the preceding claims **characterized in that** the step of receiving (91) involves generating the clock signal (CLK) from signal edge changes in at least one signal (CS, MOSI) which, in addition to the clock information, contains at least one further data information item.

7. Apparatus (602, 702, 802) which is designed to perform the steps of a method (90) according to one of the preceding claims.

8. Computer program product having program code, which is stored on a machine-readable storage medium, for carrying out the method (90) according to one of Claims 1 to 6 when the computer program product is executed on an apparatus (602, 702, 802).

9. Monitoring apparatus (502, 602, 702, 802) for monitoring a frequency signal (104), wherein the monitoring apparatus has the following features:
- an apparatus (602, 702, 802) according to Claim 7;
- a bus transmission system which is connected to the communication interface (CLK, CS, MOSI, MISO) of the apparatus (602, 702, 802) and is designed for data transmission from the apparatus (602, 702, 802) to a control unit (502);
- the control unit (502), which is designed to output a clock signal (CLK) or a control signal (CS) for the purpose of activating the apparatus (602, 702, 802), wherein the control unit is also designed to perform monitoring of the frequency signal (104) such that an error warning signal is output if the result signal does not match an expected result signal.

## Revendications

1. Procédé (90) de surveillance d'un signal de fréquence (104) qui est mis à disposition à l'intérieur d'une unité (102), le procédé présentant les étapes suivantes :
- réception (91) d'un ou de plusieurs niveaux de signal binaires d'un signal d'horloge (CLK) ou d'un signal de commande (CS) par une interface de communication (CLK, CS, MOSI, MISO), l'interface de communication (CLK, CS, MOSI, MISO) étant configurée pour transmettre des informations conformément à un protocole de communication ;
- mise à disposition (92) du signal de fréquence (104) dans l'unité ;
- comparaison (93) du signal de fréquence (104) avec une séquence temporelle de niveaux de signal du signal d'horloge (CLK) reçu par l'interface de communication (CLK, CS, MOSI, MISO) afin d'obtenir un résultat de comparaison ou commande d'un compteur (106) par le biais du signal de commande (CS) et du signal de fréquence (104) afin d'obtenir un état de comptage ; et
- identification (94) d'une qualité prédéfinie du signal de fréquence (104) lorsque le résultat de la comparaison remplit un critère prédéfini ou lorsque l'état de comptage se trouve à l'intérieur d'une plage de valeurs prédéfinie, afin de surveiller le signal de fréquence (104) par le biais de la qualité identifiée.

2. Procédé (90) selon la revendication 1, **caractérisé en ce qu'**est en outre exécutée une étape de délivrance d'un signal de contrôle (MISO) par le biais d'une ligne de signal de l'interface de communication (CLK, CS, MOSI, MISO) lorsque la qualité identifiée du signal de fréquence (104) remplit un critère défini.

3. Procédé (90) selon l'une des revendications précédentes, **caractérisé en ce qu'**à l'étape de comparaison, un deuxième compteur (206) est en outre commandé par le signal de commande (CS) et le niveau de signal du signal d'horloge (CLK) reçu par l'interface de communication (CLK, CS, MOSI, MISO), afin d'obtenir un deuxième état de comptage, la qualité prédéfinie étant identifiée à l'étape d'identification lorsque le deuxième état de comptage se trouve dans une plage de valeurs qui diffère au maximum d'une valeur de tolérance prédéfini par rapport à l'état de comptage du compteur (106).

4. Procédé (90) selon l'une des revendications précédentes, **caractérisé en ce que** l'unité (102) est un capteur, le procédé (90) comprenant en outre une étape de transmission d'un signal de mesure représentant une grandeur physique par le biais d'une ligne de signal (MISO) de l'interface de communication (CLK, CS, MOSI, MISO).

5. Procédé (90) selon l'une des revendications précédentes, **caractérisé en ce qu'**à l'étape de réception (91) a lieu une réception de données par le biais des lignes de signal de l'interface de communication (CLK, CS, MOSI, MISO) conformément à un protocole de communication normalisé, notamment un protocole de bus SPI, CAN, FlexRay ou PSI5.

6. Procédé (90) selon l'une des revendications précédentes, **caractérisé en ce qu'**à l'étape de réception (91) a lieu une génération du signal d'horloge (CLK) à partir des variations des fronts de signal d'au moins un signal (CS, MOSI) qui contient au moins une information de données en plus de l'information d'horloge.

7. Dispositif (602, 702, 802) qui est configuré pour exécuter les étapes d'un procédé (90) selon l'une des revendications précédentes.

8. Produit de programme d'ordinateur comprenant un code de programme qui est enregistré sur un support lisible par machine, destiné à mettre en oeuvre le procédé selon l'une des revendications 1 à 6 lorsque le produit de programme d'ordinateur est exécuté sur un dispositif (602, 702, 802).

9. Dispositif de surveillance (502, 602, 702, 802) destiné à la surveillance d'un signal de fréquence (104), le dispositif de surveillance présentant les caractéristiques suivantes :
- un dispositif (602, 702, 802) selon la revendication 7 ;
- un système de transmission par bus, lequel est relié avec l'interface de communication (CLK, CS, MOSI, MISO) du dispositif (602, 702, 802) et est configuré pour la transmission de données du dispositif (602, 702, 802) vers une unité de commande (502) ;
- l'unité de commande (502), laquelle est configurée pour délivrer un signal d'horloge (CLK) ou un signal de commande (CS) en vue de l'activation du dispositif (602, 702, 802), l'unité de commande étant en outre configurée pour réaliser une surveillance du signal de fréquence (104) de telle sorte qu'un signal d'alerte d'erreur est délivré lorsque le signal de résultat ne coïncide pas avec un signal de résultat attendu.
